# EUROPÄISCHE PATENTSCHRIFT

(11) **EP 3 114 191 B1**
(45) Veröffentlichungstag und Bekanntmachung des Hinweises auf die Patenterteilung: **08.05.2019**
(21) Anmeldenummer: 15728455.5
(22) Anmeldetag: 01.06.2015
(51) Int. Cl.: C09K 11/06, H05B 33/14, H01L 51/00, H01L 51/50

(54) **SEQUENTIELLE FUNKTIONALISIERUNG PHOSPHORESZENTER EMITTERSCHICHTEN**
SEQUENTIAL FUNCTIONALISATION OF PHOSPHORESCENT EMITTER LAYERS
FONCTIONNALISATION SÉQUENTIELLE DE COUCHES ÉMETTRICES PHOSPHORESCENTES

(30) Priorität: 05.06.2014 DE 102014210676
(43) Veröffentlichungstag der Anmeldung: 11.01.2017
(73) Patentinhaber: Siemens Aktiengesellschaft, 80333 München (DE)
(72) Erfinder: WECKER, Joachim, 91341 Röttenbach (DE); KRESTEL, Ana-Maria, 91052 Erlangen (DE); SCHMID, Günter, 91334 Hemhofen (DE)
(86) Internationale Anmeldenummer: PCT/EP2015/062085
(87) Internationale Veröffentlichungsnummer: WO 2015/185482

(56) Entgegenhaltungen:
- WO-A1-2012/153083
- DE-A1- 10 360 681
- JP-A- 2002 110 357
- ZHIWEI LIU ET AL: "A Codeposition Route to CuI-Pyridine Coordination Complexes for Organic Light-Emitting Diodes", JOURNAL OF THE AMERICAN CHEMICAL SOCIETY, Bd. 133, Nr. 11, 23. März 2011 (2011-03-23), Seiten 3700-3703, XP055009605, ISSN: 0002-7863, DOI: 10.1021/ja1065653

## Beschreibung

Die vorliegende Erfindung betrifft ein Verfahren zur Herstellung phosphoreszenter Emitterschichten aus mindestens einem organisch fluoreszenten Emitter F und mindestens einem Metallkomplex K umfassend organische Komplexliganden L und mindestens ein schweres Hauptgruppenmetall M ausgesucht aus der Gruppe umfassend In, Tl, Sn, Pb, Sb und Bi, wobei der organisch fluoreszente Emitter F und der Metallkomplex K jeweils einzeln und schichtweise auf einem Substrat abgeschieden und anschließend miteinander zur Reaktion gebracht werden, wobei das schwere Hauptgruppenmetall M seine Koordinationssphäre unter Aufnahme des organisch fluoreszenten Emitters F ändert.

### Stand der Technik

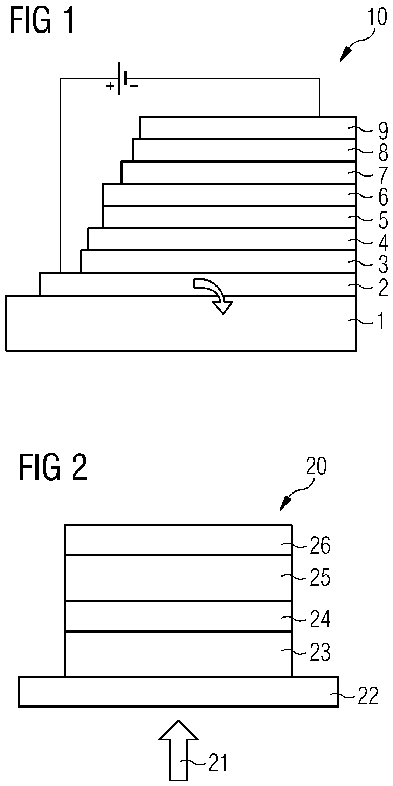

Prinzipielle Methoden zur Umwandlung von Licht in elektrischen Strom (und umgekehrt) mittels organischer Elektronik sind seit einigen Jahrzehnten bekannt. Technisch durchgesetzt, und derzeit an der Grenze zur Massenmarktreife, haben sich Mehrschichtaufbauten, wie sie zum Beispiel in Figur 1 für eine organische Licht emittierenden Diode (OLED) oder in Figur 2 für eine organische Solarzelle schematisch dargestellt sind. Obwohl die Effizienz dieser Komponenten gerade in den letzten Jahren durch den Einsatz optimierter organischer Verbindungsklassen eine deutliche Leistungssteigerung erfuhr, ergeben sich weiterhin vielversprechende Ansatzpunkte noch höhere Quantenausbeuten und damit noch höhere Wirkungsgrade bei gesenkten Materialkosten bereitzustellen.

Einer dieser Ansatzpunkte liegt in der Verwendung phosphoreszenter Emitter, sogenannter Triplett-Emitter, welche zum Beispiel in PHOLEDs (phosphorescent organic light-emitting devices) Verwendung finden. In Anbetracht der geltenden Quantenstatistik sind diese, zumindest theoretisch, in der Lage, einen internen Quanten-Wirkungsgrad von 100% zu erreichen. Dies im Gegensatz zu Dioden mit rein fluoreszenten Emittern, welche aufgrund der Quantenstatistik der injizierten Ladungsträger eine maximale interne Quantenausbeute von nur 25 % aufweisen.

Betrachtet man alleine die interne Quantenausbeute, so sind also Bauteile der organischen Elektronik, welche eine auf Phosphoreszenz basierende Umwandlung von Strom in Licht (und umgekehrt) nutzen (Triplett-Emitter/Emission), eher geeignet eine hohe Lumineszenz (cd/m²) bzw. Effizienz (cd/A, lm/W) bereitzustellen. Im Bereich der Verbindungen, welche zur Triplett-Emission befähigt sind, gibt es allerdings mehrere Randbedingungen zu beachten. Zwar tritt Phosphoreszenz auch in Verbindungen der Elemente der vierten und fünften Periode des Periodensystems auf, durchgesetzt haben sich in oben genannten Anwendungen jedoch die Komplexe der Metalle der 6. Periode. Je nach Lage der Elemente in dieser Periode ist dabei der Ursprung der Phosphoreszenz innerhalb der Orbitalstruktur der Komplexe unterschiedlich gewichtet.

Bei den Lanthanoiden ist sowohl das HOMO (Highest Occupied Molecular Orbital) als auch das LUMO (Lowest Unoccupied Molecular Orbital) vorwiegend metallzentriert, d.h. der Anteil der Liganden-Orbitale ist relativ schwach ausgeprägt. Dies führt dazu, dass die Emissionswellenlänge (Farbe) der Emitter fast ausschließlich durch die Bandstruktur des Metalls festgelegt ist (Beispiele Europium = rot, Terbium = grün). Aufgrund der starken Abschirmung der f-Elektronen dieser Metalle vermögen an das Metall gekoppelte Liganden die Energien der fⁿ-Konfiguration der Metalle nur um circa 100 cm⁻¹ aufzuspalten, sodass sich die Spektroskopie durch ihr Ligandenfeld der d-Ionen von derjenigen der f-Ionen erheblich unterscheidet. Bei Ionen der Lanthaniden resultiert die Farbe aus Übergängen von f- in unbesetzte s-, p- und d-Orbitale.

Geht man entlang der Periode zu den Elementen Osmium, Iridium, Platin und Gold, so spalten Ligandenfelder die Metallorbitale um einen Faktor 10 - 100mal mehr auf als im Falle der Lanthanoiden. Damit lässt sich durch Variation der Liganden praktisch das gesamte sichtbare Wellenlängenspektrum mit diesen Elementen darstellen. Durch die starke Kopplung des Bahndrehimpulses des Metallatoms mit dem Spindrehimpuls der Elektronen wird in den Emittern Phosphoreszenz erhalten. Das HOMO ist dabei meist metallzentriert, während das LUMO meist ligandzentriert ist. Die strahlenden Übergänge werden daher als Metall-Ligand-Charge-Transferübergänge (MLCT) bezeichnet.

Sowohl OLEDs als auch OLEECs (organic light-emitting electrochemical cell) nutzen derzeit fast ausschließlich Iridium-Komplexe als Emitter. Im Falle der OLEDs sind die Emitter-Komplexe ungeladen, im Falle der OLEECs werden ionische d.h. geladene Emitter-Komplexe genutzt. Die Verwendung von Iridium in diesen Bauteilen hat jedoch einen gravierenden Nachteil. Die Jahresproduktion von Iridium liegt weit unter 10 t (3t in 2000). Dies führt dazu, dass die Material-Kosten einen signifikanten Beitrag zu den Herstellkosten organisch elektrischer Bauteile leisten. Hinzu kommt, dass Iridium-Emitter nicht in der Lage sind, effizient das gesamte Spektrum des sichtbaren Lichts abzubilden. So sind beispielsweise stabile blaue Iridium-Emitter eher selten, welches einer flexiblen Verwendung dieser Materialien in OLED oder OLECC Anwendungen entgegensteht.

In der neueren Literatur finden sich hingegen einige Ansätze, welche ein "Triplett-Harvesting" auch mit nicht auf Iridium basierenden Emittern vorschlagen. So verweisen zum Beispiel Omary et al. in "Enhancement of the Phosphorescence of Organic Luminophores upon interaction with a Mercury Trifunctional Lewis Acid" (Mohammad A. Omary, Refaie M. Kassab, Mason R. Haneline, O. Elbjeirami, and Francois P. Gabbai, Inorg. Chem. 2003, 42, 2176-2178) auf die Möglichkeit zur Erreichung einer ausreichenden Phosphoreszenz rein organischer Emitter durch den Einsatz von Quecksilber. Bedingt durch den Schweratomeffekt des Quecksilbers in einer Matrix aus organischen Liganden wird ein Singulett-Triplett-/Triplett-Singulett-Übergang der angeregten Elektronen der organischen Matrix quantenmechanisch ermöglicht (ISC, inter system crossing), welches in einer deutlichen Verringerung der Lebensdauer der angeregten elektronischen (Triplett) Zustände resultiert und eine unerwünschte Sättigung der Besetzung dieser Zustände vermeidet. Ursächlich für diesen Mechanismus ist die Spin-Bahnkopplung des Quecksilber-Schweratoms mit den angeregten Elektronen der organischen Matrix. Nachteilig hingegen ist, dass der Einsatz von Quecksilber aufgrund von toxischen und umweltpolitischen Aspekten problematisch ist.

Eine Möglichkeit eine hinreichende Quantenausbeute auf Basis rein organischer Phosphoreszenz-Emitter zu erhalten wird zum Beispiel durch Bolton et al. in NATURE CHEMISTRY, 2011, 1-6 beschrieben ("Activating efficient phosphorescence from purely organic materials by crystal design", Onas Bolton, Kangwon Lee, Hyong-Jun Kim, Kevin Y. Lin and Jinsang Kim. NATURE CHEMISTRY, 2011, 1-6). An dieser Stelle wird vorgestellt, dass der Einbau schwerer Halogenide in einen Kristall aus einer organischen Matrix zu hohen Quantenausbeuten durch phosphoreszierende organische Emitter führt. Nachteilig an dieser Lösung ist hingegen, dass für diesen Effekt anscheinend ein bestimmter Abstand zwischen den schweren Halogeniden und der organischen Matrix und ein kristalliner Aufbau nötig sind. Dies würde einer kostengünstigen industriellen Fertigung von organischen Bauelementen entgegenstehen.

Die WO 2012/016074 A1 hingegen beschreibt eine dünne Schicht umfassend eine Verbindung der Formel 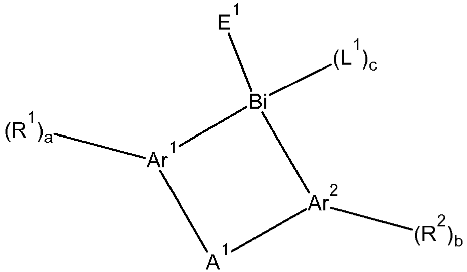 wobei Ar¹ und Ar² jeweils unabhängig ein C3-30 aromatischer Ring sind; R¹ und R² ein Substituent sind; a und b jeweils unabhängig eine ganze Zahl von 0 bis 12 sind, wobei, wenn a 2 oder mehr ist, jeder Rest R1 gegebenenfalls voneinander verschieden ist, und zwei Reste R¹ gegebenenfalls miteinander gebunden sind, um eine Ringstruktur zu bilden, und, wenn b 2 oder mehr ist, jeder Rest R² gegebenenfalls voneinander verschieden ist und zwei Reste R² gegebenenfalls miteinander gebunden sind, um eine Ringstruktur zu bilden; A¹ irgendeine Art einer direkten Bindung, -O-, -S-, -S(=O)-, -S(=O)₂-,-PR³-, -NR⁴- und -C(R⁵)₂- ist; R³ ein Wasserstoffatom oder ein Substituent ist; R⁴ ein Wasserstoffatom oder ein Substituent ist; R⁵ ein Wasserstoffatom oder ein Substituent ist und zwei Reste R⁵ gegebenenfalls voneinander verschieden sind; E¹ ein einwertiger Rest mit 50 oder weniger Kohlenstoffatomen ist; L¹ ein Ligand mit 50 oder weniger Kohlenstoffatomen ist; c eine ganze Zahl von 0 bis 3 ist, wobei, wenn c 2 oder mehr ist, jeder Rest L¹ gegebenenfalls voneinander verschieden ist; und jede Kombination einer Kombination von E¹ und Ar¹ und einer Kombination von E¹ und Ar² gegebenenfalls eine Bindung bildet; und, wenn c 1 bis 3 ist, jede Kombination einer Kombination von L¹ und E¹, einer Kombination von L¹ und Ar¹, einer Kombination von L¹ und Ar² und einer Kombination von L¹ und L¹ gegebenenfalls eine Bindung bildet. Nachteilig hingegen ist, dass die beschriebenen Verbindungen nur eine ungenügende Quantenausbeute aufweisen und in Lösung nicht ausreichend stabil sind, sodass sie sich zersetzen.

Die DE 103 60 681 A1 offenbart Hauptgruppenmetall-Diketonatokomplexe nach folgender Formel 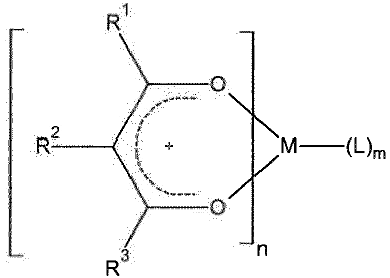 als phosphoreszente Emitter-Moleküle in organischen Leuchtdioden (OLEDs), worin M Tl(I), Pb(II) und Bi(III) sein können. Des Weiteren wird die Verwendung dieser Hauptgruppenmetall-Diketonatokomplexe als Licht-emittierende Schichten in OLEDs, Licht-emittierende Schichten, enthaltend mindestens einen Hauptgruppenmetall-Diketonatokomplex, eine OLED, enthaltend diese Licht-emittierende Schicht, sowie Vorrichtungen, die eine erfindungsgemäßes OLED enthalten offenbart. In Versuchen hingegen konnte gezeigt werden, dass die unter strengen Wasserausschluss synthetisierten, oben genannten Verbindungen keine auf Phosphoreszenz basierende Emission nach elektronischer Anregung zeigen. Hochwahrscheinlich rühren die angeführten phosphoreszenten Emissionen von nicht näher bestimmbaren Oxo-Clustern her, welche sich unkontrolliert, zum Beispiel durch Hydrolyse im Rahmen der Herstellung, gebildet haben. Nachteilig an dieser speziellen Lösung ist, dass das π-System dieser Acetylacetonat-Liganden, insbesondere der beschrieben vollfluorierten Varianten, wenig ausgeprägt ist und als alleinige Phosphoreszenz-Emitter nur geringe Phosphoreszenz-Ausbeuten erlaubt.

Ein weiteres Verfahren zur Herstellung organisch elektrolumineszenter Materialien und organisch elektrolumineszenter Elemente mit hoher lumineszenter Intensität und langer Lebensdauer wird beispielsweise in der JP 2002 110357 A offenbart.

Soweit in den oben genannten Dokumenten überhaupt angegeben, werden die Phosphoreszenz-Emitter durch Standardverfahren wie beispielsweise Abscheidung/Reaktion oder Kristallisation aus Lösung oder Co-Evaporation hergestellt. Weitergehende Methoden zur Herstellung besonders effektiver Schichten, welche besonders vorteilhafte Phosphoreszenz-Emitterkomplexe aufweisen, werden dabei nicht offenbart.

Es ist daher die Aufgabe der vorliegenden Erfindung ein verbessertes Verfahren zur Herstellung phosphoreszenter Emitterschichten bereitzustellen, welches sich kostengünstig realisieren lässt und zu effizienten und langlebigen Emitterschichten führt.

Gelöst wird diese Aufgabe durch die Merkmale des Anspruchs 1. Besondere Ausführungsformen der Erfindung werden in den Unteransprüchen wiedergegeben.

Erfindungsgemäß ist ein Verfahren zur Herstellung phosphoreszenter Emitterschichten aus mindestens einem organisch fluoreszenten Emitter F und mindestens einem Metallkomplex K umfassend organische Komplexliganden L und mindestens ein schweres Hauptgruppenmetall M ausgesucht aus der Gruppe umfassend In, Tl, Sn, Pb, Sb und Bi, dadurch gekennzeichnet, dass der organisch fluoreszente Emitter F und der Metallkomplex K jeweils einzeln und schichtweise auf einem Substrat abgeschieden und anschließend miteinander zur Reaktion gebracht werden, wobei das schwere Hauptgruppenmetall M seine Koordinationssphäre unter Aufnahme des organisch fluoreszenten Emitters F ändert. Es wurde gefunden, dass mittels dieses Verfahrens einfach und kostengünstig Schichten mit bei Raumtemperatur phosphoreszenten organischen Emittern erhalten werden, welche eine hohe interne Quanteneffizienz, hohe Leuchtdichten, schnelles Ansprechverhalten und gute Langzeitstabilitäten aufweisen. Ohne durch die Theorie gebunden zu sein, wird die Phosphoreszenz der eigentlich fluoreszenten organischen Emitter durch Anlagerung direkt in und an die Koordinationssphäre des schweren Hauptgruppenmetalls induziert. Aufgrund des Aufbaus des erhältlichen Komplexes, kann zudem durch Modifikation der Liganden des Komplexes, insbesondere deren π-System, die Emissionswellenlänge der Emitter durchgestimmt werden. Möglich ist insbesondere der Aufbau heteroleptischer Komplexe oder Anlagerungs-Verbindungen, welche Emissionen über die Orbitale unterschiedlich aufgebauter Liganden/Emitter ermöglicht. Dies erhöht zusätzlich die Vielfalt zur Herstellung rein organischer phosphoreszenter Emitter. Ohne durch die Theorie gebunden zu sein können sich durch die sequenzielle, d.h. schichtweise, Abscheidung erst der einen und daran anschließende Abscheidung der 2. Komponente durch den anschließenden Reaktionsschritt, besondere Schichtstrukturen ergeben, welche durch ein gleichzeitiges Abscheiden beider Komponenten nicht erhältlich sind. So können durch den sequenziellen Abscheidungsprozess mit anschließender Reaktion hochwahrscheinlich nicht-stöchiometrische Emitter-Metall-Komplexe erhalten werden, in welchem der fluoreszente Emitter F nicht nur als Ligand in die direkte Koordinationssphäre des Hauptgruppenmetalls aufgenommen wird, sondern zusätzlich auch fluoreszente Emitter F auf weiteren, thermodynamisch bevorzugten Anlagerungsplätzen um den Metallkomplex herum vorliegen. Dabei scheinen die nicht in die nächste Koordinationssphäre des Metallkomplexes eingebauten Emitter F trotzdem in der Lage zu sein, durch den Schwermetallatomeffekt des Metalls zur Phosphoreszenz befähigt zu werden. Dadurch, dass die eingebauten Emitter F partiell nicht in die direkte Koordinationssphäre des Metallatoms aufgenommen werden, ergibt sich für diese zudem die Möglichkeit, mit mehreren Metallatomen aus der näheren Umgebung zu wechselwirken. Es ergibt sich demzufolge eine Situation, in welcher nach der Reaktion physikalisch unterschiedlich gebundene Emitter F vorliegen. Zum einen die Emitter F in der direkten Koordinationssphäre des Schwermetallatoms und zum anderen Emitter F, welche nicht direkt an das Schwermetallatom gebunden sind, sondern weiter entfernte Positionen außerhalb der direkten Koordinationssphäre des Metallatoms besetzen. Durch diesen unterschiedlichen Abstand (Bindung/Koordination) der fluoreszenten Emitter F an das Metallatom können unterschiedliche Phosphoreszenz-Eigenschaften der organisch elektrischen Schicht erhalten werden. Durch die zusätzlichen Emitter, welche zwischen den Metallkomplexen angeordnet sind, lässt sich zudem das Emissions- und Absorptionsverhalten der Schicht beeinflussen. Insbesondere scheint dabei die sequenzielle Abscheidung erst der einen und dann der anderen Komponente mit anschließendem Reaktionsschritt, zu homogenen Schichten mit definierten "Zwischenkomplex-Positionen" der zusätzlichen Emitter zu führen. Ohne durch die Theorie gebunden zu sein lässt sich dies hochwahrscheinlich auf den Diffusionsprozess zurückführen, welcher erst zu einem Einbau der fluoreszenten Emitter in die direkte Koordinationssphäre des Schwermetallatoms und anschließend zu einer Besetzung thermodynamisch günstiger Plätze in Nachbarschaft der Schwermetallatom-Komplexe führt. Dieser Aufbau organischer Schichten ist durch andere Methoden, insbesondere durch eine gleichzeitige Abscheidung beider Komponenten, entweder aus thermodynamischen oder kinetischen Gründen nicht erhältlich. Der Einbau der organischen Emitter an den unterschiedlichen Positionen lässt sich mit dem für den Fachmann bekannten Methoden analytisch nachweisen. Dies beispielsweise durch IR- oder NMR-Spektroskopie oder durch Messung der Phosphoreszenzeigenschaften der Schichten nach der Reaktion.

Die Änderung der direkten Koordinationssphäre des Metalls kann dabei sowohl aus einer Erweiterung der Anzahl koordinierter Liganden/Emitter, einem Ersatz einer oder mehrerer Liganden durch Emitter oder sogar in der Reduzierung der Anzahl koordinierter Liganden durch die Addukt-/Anlagerungs-/Komplexbildung mit dem Emitter bestehen. Dies als Funktion der sterischen und elektronischen Voraussetzungen der Emitter und Liganden, der Koordinationsstärke der einzelnen Liganden und den gewählten Reaktionsbedingungen beim anschließenden zur Reaktion bringen. Im Falle der Adduktbildung oder Koordination des Emitters an das schwere Hauptgruppenmetallatom muss zwischen dem Schweratom und dem organischen Emittern keine σ-Bindung ausgebildet werden. Es reichen schwache elektrostatische und/oder π-Wechselwirkungen zwischen Metall und Emitter. Durch die Wechselwirkung mit dem Schwermetallatom kann sich allerdings auch die Energielage des HO-MOs/LUMOs des oder der fluoreszenten Emitter ändern. Bedingt durch den Schweratomeffekt kann es zudem zu einer Spin-Bahnkopplung zwischen dem Emitter-Elektronen und dem Metallatomkern kommen, welches dazu führt, dass bisher spin-verbotene elektronische Übergänge quantenmechanisch erlaubt werden. Dadurch sinkt die Lebensdauer der elektronisch angeregten Zustände und somit wird bei Raumtemperatur ein effektiver Phosphoreszenzkanal (mit Triplett-Singulett-Übergängen) eröffnet. Das Metall beteiligt sich nicht direkt an der Emission, es stellt lediglich seinen Bahndrehimpuls zur Verfügung. Dies im Gegensatz zu der bei Raumtemperatur rein fluoreszenten Emission der organischen Emitter ohne Schwermetallkoordination.

Die erfindungsgemäß erhaltenen Emitterschichten können dabei neutraler oder ionischer Natur sein und somit OLED oder OLECtypisches Emissionsverhalten zeigen.

Unter einer organisch elektrischen Schicht im Sinne der Erfindung wird eine Schicht umfassend organischen Emitter, Metallkomplexe enthaltend schwere Hauptgruppenmetalle und optional Matrixmaterialien verstanden. Die Schicht kann auch amorph sein, d.h. die einzelnen Bestandteile in dieser Schicht weisen keine periodische Anordnung über einen größeren Bereich (Fernordnung) auf. Insbesondere wird darunter nicht das Vorliegen eines Einkristalls oder kristalliner Bereiche mit einer Größenausdehnung von größer oder gleich 50 nm verstanden. Die in der Schicht vorliegenden Verbindungen können aber hingegen eine gewisse Nahordnung (Abstand und Orientierung) zu Ihren nächsten Nachbarn aufweisen. Diese Bereiche sind aber statistisch verteilt. Innerhalb eines Röntgendiffraktogramms, zum Beispiel erhalten durch eine XRD-Messung (Röntgen-Pulverdiffraktometrie), zeichnet sich die amorphe Schicht durch einen breiten Halo aus. Überraschenderweise wurde gefunden, dass eine amorphe Anordnung der Bereiche in der Schicht zum Erhalt einer ausreichenden Phosphoreszenz-Ausbeute genügt. Dies im Gegensatz zu experimentellen Ergebnissen, welche eine sehr regelmäßige Anordnung einer Vielzahl von Metallatomen und Emittern als Bedingung zum Erhalt hoher Phosphoreszenz-Ausbeuten voraussetzen.

Bedingt durch den Einfluss des Schwermetalls wird bei Raumtemperatur ein nennenswerter Phosphoreszenz-Beitrag des organischen fluoreszenten Emitters erhalten. Raumtemperatur im Sinne der Erfindung ist der Temperaturbereich von -50°C bis 150°C (der übliche Betriebstemperaturbereich für organische Elektronik). In diesem Temperaturbereich liefern die phosphoreszenten Übergänge eines oder mehrerer fluoreszenter Emitter ohne Schwermetallatomeinfluss in der Regel keine nennenswerten Beiträge zur Emission rein organischer Emitter.

Organisch fluoreszente Emitter F sind organische Moleküle, welche entweder partiell oder insgesamt aromatischen Charakter mit delokalisierten π-Elektronen aufweisen können. Des Weiteren können diese Moleküle Heteroatome wie N, N-R, O, S, Se, Si oder Metalle wie Li oder Al, Ga oder Zn aufweisen. R steht in diesen Fall für einen alkyl- oder aromatischen Rest. Diese Moleküle zeigen als Feststoff oder in Lösung nach elektronischer Anregung Fluoreszenz, d.h. elektronische (S1-S0) singulett-singulett Übergänge. Phosphoreszente Übergänge (T-S) sind aufgrund der quantenmechanischen Ausschlussregeln (Spinumkehr) bei Raumtemperatur nicht beobachtbar. Die Lebensdauer der fluoreszenten Übergänge in den erfindungsgemäß einsetzbaren organischen fluoreszenten Emittern kann ohne Annäherung an das schwere Metallatom in einem Bereich unterhalb von 100 ns liegen.

Bevorzugt kann es sich bei den organisch fluoreszenten Emittern F um C10-C60 Heteroaromaten, des Weiteren bevorzugt um C15-C50 Heteroaromaten handeln. In speziellen Anwendungsfällen haben sich die Sauerstoff und die Stickstoff enthaltenen Heteroaromaten als besonders günstig erwiesen. Des Weiteren können organisch fluoreszente Emitter bevorzugt innerhalb des erfindungsgemäßen Verfahrens eingesetzt werden, deren Triplett-Zustand größer oder gleich -5 eV und kleiner oder gleich 5 eV vom S0-Zustand entfernt ist. Mit diesen elektronischen Rahmenbedingungen können sich im Rahmen des erfindungsgemäßen Verfahrens besonders hohe Quantenausbeuten erhalten lassen.

Im Rahmen des erfindungsgemäßen Verfahrens werden Metallkomplexe enthaltend schwere Hauptgruppenmetalle M aus der Gruppe umfassend In, Tl, Sn, Pb, Sb und Bi eingesetzt. Diese Metallkomplexe können organische Komplexliganden aufweisen und sind besonders aufgrund ihrer Verfügbarkeit, ihres Beschaffungspreises und ihrer Fähigkeit zur Ausbildung einer ausgeprägten Spin-Bahnkopplung und der Möglichkeit zur Erweiterung der Koordinationssphäre bevorzugt. Es können auch mehrere unterschiedliche Metalle aus der oben genannten Gruppe im erfindungsgemäß einsetzbaren Metallkomplex enthalten sein. Diese Gruppe ist besonders geeignet, da die in ihr aufgeführten Elemente einen besonders hohen Bahndrehimpuls aufweisen, welcher effektive Phosphoreszenz-Übergänge in den organischen Emittern F ermöglicht. Zudem sind diese Metalle in hoher Reinheit zu relativ niedrigen Preisen verfügbar.

In einer besonderen Ausführungsvariante kann die Gruppe vorteilhafterweise auch Sn, Pb und Bi umfassen. Diese Metalle besitzen zudem den Vorzug, dass sie sich auch sehr gut aus Lösungen heraus verarbeiten lassen.

Bevorzugt kann die Koordination der Metalle mit organischen Liganden erfolgen, welche terminal, bi-dentat, tri-dentat oder hetero-bimetallisch mit dem Metallatom verbrückt sind. Vorteilhafte Ausgestaltungen können sich ergeben, wenn die Koordination der Liganden an das Metallatom über zwei Sauerstoffatome erfolgt. Ohne durch die Theorie gebunden zu sein, können diese Substituenten im Rahmen des Abscheideverfahrens effizient durch die organischen Emitter verdrängt oder die Koordinationssphäre erweitert werden und so zu einer hohen Phosphoreszenz-Ausbeute beitragen. Des Weiteren kann mittels dieser Substituenten die Emissionswellenlänge des Phosphoreszenzlichtes durch Ligand-Ligand-Übergänge abgestimmt werden. Bevorzugt können dieserart koordinierte Liganden aromatische π-Systeme aufweisen, welche mindestens 10 C-Atome aufweisen. Dies kann zu einer größeren Aufweitung der Emissionswellenlängen bei Ligand-Ligand-Übergängen beitragen.

Das schwere Hauptgruppenmetall M ändert unter Aufnahme des organisch fluoreszenten Emitters F seine Koordinationssphäre. Ohne durch die Theorie gebunden zu sein, werden im erfindungsgemäßen Verfahren die organischen Emitter in die Nähe des Hauptgruppen Metalls gebracht. Eine Untermenge der Liganden wird daraufhin direkt in die Koordinationssphäre des Schwermetallatoms eingebaut. Daraufhin ändert sich die Anordnung der Liganden des Metallkomplexes. Dies bedingt durch van-der-Waals-, Coulomb-, π-σ- oder σ-Wechselwirkungen des organischen Emitters mit dem Metall. Eine σ-Wechselwirkungen ist zur Ausbildung der Phosphoreszenz nicht vonnöten, kann aber auch ausgebildet werden. Die Koordinationssphäre des Metalls kann durch die Nähe des organischen Emitters aufgeweitet werden. Es kann auch zur Substitution eines einzelnen oder mehrerer Liganden durch den organischen Emitter kommen. Des Weiteren ist es auch möglich, dass die Anzahl der Liganden durch die Änderung der Koordinationssphäre reduziert wird. Dies zum Beispiel durch das Verdrängen einer oder mehrerer Liganden durch die Aufnahme des fluoreszenten organischen Emitters. Die restliche Menge an organisch fluoreszenten Emitter wird nicht direkt an das Metallatom des Komplexes gebunden, sondern besetzt thermodynamisch günstige Plätze zwischen den Metallkomplexen. Trotzdem die organisch fluoreszenten Emitter F nicht direkt in der 1. Koordinationssphäre des Metalls angeordnet sind, reicht die räumliche Nähe auf den Zwischen-Komplexplätzen aus, um durch den Schwermetallatomeffekt des Hauptgruppenmetalls die Phosphoreszenz-Kanäle des fluoreszenten Emitters zu öffnen. Dadurch werden 2 unterschiedliche Emitter-Spezies erhalten, welche sich in ihren Phosphoreszenz-Eigenschaften unterscheiden. Dies kann insbesondere auch dadurch begründet sein, dass der Emitter, welcher nicht direkt in die Koordinationssphäre des Metallatoms eingebunden ist, durch mehrere Schwermetall-Atome gleichzeitig beeinflusst wird.

Das "zur Reaktion bringen" der organisch fluoreszenten Emitter F und der Metallkomplexe kann also unterschiedliche Stufen beinhalten. Zum einen eine 1. Stufe, in welcher die sich in unterschiedlichen Schichten befindenden Substanzen durch einen Diffusionsprozess in unmittelbar räumliche Nähe gebracht werden. Einer 2. Stufe, in welcher die Koordinationssphäre des Metallatoms sich durch Aufnahme des organischen Emitters ändert. In einer 3. Stufe können dann weitere organische Emitter F thermodynamisch günstige Plätze zwischen den Metallkomplexen einnehmen und an diesen Stellen durch Wechselwirkungen mit mehreren Metallkomplexen auch zur Phosphoreszenz befähigt werden. Hierdurch entstehen Komplexverbindungen mit einer nicht stöchiometrischen (d.h. geradzahligen) Anzahl an Emittern pro Metallkomplex.

Die organisch fluoreszenten Emitter F und die Metallkomplexe werden insbesondere dann einzeln und schichtweise abgeschieden, wenn sie nicht gleichzeitig, zum Beispiel innerhalb desselben Lösungsmittels gelöst aufgetragen, gleichzeitig in unterschiedlichen Lösungsmitteln gelöst aufgetragen, gleichzeitig aus verschiedenen Quellen auf ein Substrat aufgedampft oder gleichzeitig aus einer Quelle auf ein Substrat aufgedampft werden. Erfindungsgemäß ist erst das Auftragen der einen Komponente auf das Substrat, wobei diese Komponente frei von der 2. Komponente ist und dann das Auftragen der 2. Komponente, wobei die 2. Komponente frei von der 1. Komponente ist, vorgesehen. Zweckmäßigerweise kann das Auftragen der Komponenten homogen auf dem Substrat erfolgen, so dass sich Schichten gleichmäßiger Dicke ergeben. Es lassen sich aber auch Ausgestaltung denken, indem die Schichten nur partiell auf Teilbereiche des Substrats oder mit unterschiedlicher Dicke aufgetragen werden. Dieses nur partielle Auftragen führt auch zu Schichten im Sinne der Erfindung. Das einzelne Auftragen von Schichten im Rahmen eines Lösemittelprozesses kann beispielsweise dadurch erfolgen, dass erst eine 1. Schicht einer 1. Komponente aufgetragen, dann das Lösemittel entfernt und anschließend eine 2. Schicht mit (oder ohne) einem Lösemittel aufgetragen wird. Das zur Reaktion bringen kann in diesem Fall gleichzeitig oder sequenziell zum Abdampfen des letzteren Lösungsmittels erfolgen.

Zusätzlich zum Metallkomplex und zum organischen Emitter können im Rahmen des erfindungsgemäßen Verfahrens noch weitere nicht koordinierende Matrixmaterialien innerhalb der Schichten abgeschieden werden. Dieses oder diese Matrixmaterialien können beispielsweise die elektronische Leitfähigkeit der Schicht beeinflussen oder allgemein Einfluss auf die Beweglichkeit des organischen Emitters oder des Metallkomplexes nehmen. Geeignete Matrixmaterialien können ausgewählt sein aus der Gruppe 2,2',7,7'-tetrakis(carbazol-9-yl)-9,9-spirobifluoren; 2,7-bis(carbazol-9-yl)-9,9-ditolylfluoren; 9,9-bis[4-(carbazol-9-yl)-phenyl]fluoren; 2,7-bis(carbazol-9-yl)-9,9-spirobifluoren; 1,4-bis(triphenylsilyl)benzen; 1,3-bis(triphenylsilyl)benzen; Bis(4-N,N-diethylamino-2-methylphenyl)-4-methylphenylmethane; 2,7-bis(carbazol-9-yl)-9,9-dioctylfluoren; 4,4"-di(triphenylsilyl)-p-terphenyl; 4,4'-di(triphenylsilyl)-biphenyl; 9-(4-tert-butylphenyl)-3,6-bis(triphenylsilyl)-9Hcarbazol; 9-(4-tert-butylphenyl)-3,6-ditrityl-9H-carbazol; 9-(4-tert-butylphenyl)-3,6-bis(9-(4-methoxyphenyl)-9H-fluoren-9-yl)-9H-carbazol; 2,6-bis(3-(9H-carbazol-9-yl)phenyl)pyridine; 3,5-bis(3-(9H-carbazol-9-yl)phenyl)pyridine, Triphenyl(4-(9-phenyl-9H-fluoren-9-yl)phenyl)silane; 9,9-dimethyl-N,N-diphenyl-7-(4-(1-phenyl-1Hbenzo[d]imidazol-2-yl)phenyl)-9H-fluoren-2-amine; 3,5-bis(3-(9H-carbazol-9-yl)phenyl)pyridine; 9,9-spirobifluoren-2-yl-diphenyl-phosphine oxide; 9,9'-(5-(triphenylsilyl)-1,3-phenylen)bis(9Hcarbazol); 4,4,8,8,-12,12-hexa-p-tolyl-4H-8H-12H-12C-Azadibenzo[cd,mn]pyren; 2,2'-bis(4-(carbazol-9-yl)phenyl)-biphenyl; 2,8-bis(diphenylphosphoryl)dibenzo[b,d]Thiophen; Bis(2-methylphenyl)diphenylsilan; Bis[3,5-di(9H-carbazol-9-yl)phenyl]diphenylsilan; 3,6-bis(carbazol-9-yl)-9-(2-ethylhexyl)-9Hcarbazol; 3-(diphenylphosphoryl)-9-(4-(diphenylphosphoryl)phenyl)-9H-carbazol; 3,6-bis[(3,5-diphenyl)phenyl]-9-phenyl-carbazol; 2,8-di(9H-carbazol-9-yl)dibenzo[b,d]thiophen; 10-(4'-(diphenylamino)biphenyl-4-yl)acridin-9(10H)-on; 2,7-bis(diphenylphosphoryl)-9,9'-spirobi[fluoren]; 1,4-bis((9H-carbazol-9-yl)methyl)benzen; Bis-4-(N-carbazolyl)phenyl)phenylphosphineoxid; 2,7-Bis(diphenylphosphoryl)-9-(4-diphenylamino)phenyl-9'-phenyl-fluoren; Di(4-(6H-indolo[3,2-b]quinoxalin-6-yl)phenyl)diphenylsilan; Di(4-(6H-indolo[3,2-b]quinoxalin-6-yl)phenyl)diphenylmethan; Bis[3,5-di(9H-carbazol-9-yl)phenyl]diphenylsilan; 2,6,14-Tris(carbazol-9-yl)triptycen; 2,6,14-Tris(diphenylphosphine-oxid)triptycen; 2,6,14-Tris(diphenyl-amino)triptycen; 2,7-bis(diphenylphosphoryl)-9-phenyl-9H-carbazol; Tris[4-(9-phenylfluoren-9-yl)phenyl]aminebiphenyl-3-amin); 2,7-Bis(diphenylphosphoryl)spiro[fluoren-7,11'-benzofluoren].

Die vorliegende Erfindung wird in Verbindung mit weiteren Aspekten und Ausführungsformen nachfolgend näher beschrieben. Sie können beliebig miteinander kombiniert werden, sofern sich aus dem Zusammenhang nicht eindeutig das Gegenteil ergibt.

In einer bevorzugten Ausführungsform des Verfahrens, kann das zur Reaktion bringen durch Hitzeeinwirkung bei einer Temperatur von größer oder gleich 50 °C und kleiner oder gleich 300 °C erfolgen. Dieser Temperaturbereich hat sich zur Herstellung homogener und effizienter phosphoreszenter Emitterschichten als besonders geeignet erwiesen. Zum einen wird durch diesen Temperaturbereich eine effiziente Diffusion der organischen Emitter F und der Metallkomplexe erreicht und zum anderen ermöglicht dieser Temperaturbereich ein effizientes zur Reaktion bringen der einzelnen Emitter-Spezies, wobei die fluoreszenten Emitter F verlässlich in die Metallkomplexe eingebaut werden. Teilweise liegen diese Temperaturen oberhalb des Schmelzpunktes bzw. des Erweichungspunktes einer Komponente. Tiefere Temperaturen sind nicht erfindungsgemäß, da nur ein unvollständiger Diffusionsprozess zu erwarten ist. Des Weiteren würden die Prozesszeiten unnötig verlängert. Hinzu kommt auch noch, dass die Einstellung thermodynamisch günstiger Positionen außerhalb der Metallkomplexe nicht mit hinreichender Geschwindigkeit erreicht werden kann. Höhere Temperaturen sind nicht erfindungsgemäß, da dies innerhalb der Schicht zu unerwünschten Nebenreaktion führen kann. Die Hitzeeinwirkung kann dabei durch die dem Fachmann gängigen Methoden bewirkt werden, beispielsweise durch Konvektion oder Strahlungswärme (z.B. IR- oder Mikrowellenstrahlung). Die Zeitdauer des zur Reaktion bringen kann dabei als Funktion der Schichtdicken und der verwendeten Verbindungen frei gewählt werden und kann zweckmäßigerweise in einem Bereich zwischen größer oder gleich 1 Sekunde und kleiner oder gleich 12 Stunden, bevorzugt größer oder gleich 60 Sekunden und kleiner oder gleich 1 Stunde liegen.

In einer weiteren Charakteristik des Verfahren kann das Schichtdickenverhältnis zwischen organisch fluoreszenter Emitter- und Metallkomplexschicht vor der Reaktion größer oder gleich 0,1 und kleiner oder gleich 15 betragen. Durch das Aufbringen der einzelnen Schichten lassen sich vorteilhafterweise auch die Konzentrationsverhältnisse von organischen Emitter und Metallkomplex über die Schichtdickenverhältnisse der einzelnen Schichten steuern. So kann zum Beispiel im Rahmen eines Vakuumprozesses eine konstante Abscheidungsrate der beiden Quellen gewählt und das Molverhältnis der beiden Spezies in der resultierenden, homogenen Schicht über die Dicke der einzelnen Schichten eingestellt werden. Die oben angegebenen Schichtdickenverhältnisse ergeben sich dabei aus dem Quotient der Schichtdicken von Emitter- zu Metallkomplexschicht. Im Falle eines Lösemittelprozesses werden die Schichtdicken der lösemittelfreien Schichten betrachtet. Die Schichtdicke einer Schicht kann sich dabei aus rechnerischen Überlegungen, zum Beispiel aus der Aufdampfrate oder der Konzentration der Spezies im Lösemittel, ergeben oder mittels einer Röntgenstrukturanalyse nach Auftragen der Schichten erhalten werden. Größere Unterschiede im Schichtdickenverhältnis sind nicht zweckmäßig, da dies zu längeren Diffusionswegen führen kann, welches einer effizienten Herstellung entgegenstehen kann.

In einer zusätzlichen Ausgestaltung des Verfahrens kann die Schichtdicke einer einzelnen Lage vor der Reaktion größer oder gleich 0,01 nm und kleiner oder gleich 100 nm betragen. Dieser angegebene Bereich absoluter Schichtdicken hat sich im Rahmen von Vakuum- oder Nassprozessen als besonders geeignet erwiesen. Innerhalb dieses Bereiches, lässt sich im Rahmen des zur Reaktion bringen innerhalb vernünftiger Prozesszeiten eine homogene Schicht herstellen, in welcher die einzelnen Bestandteile gleichmäßig verteilt sind. Dies ist hochwahrscheinlich durch die Diffusionskoeffizienten der gewählten Substanzen im angegebenen Temperaturbereich bedingt. Größere Schichtdicken hingegen können unvorteilhaft sein, da sich dadurch die Prozesszeiten verlängern würden. Des Weiteren können bei größeren Schichtdicken das Entstehen lokaler Gradienten oder der Einbau organischer Emitter F an nicht thermodynamisch bevorzugten Stellen nicht ausgeschlossen werden. Derartige Gradienten können zur Einstellung bestimmter Farborte wünschenswert sein.

In einer weiteren, bevorzugten Ausführungsform kann das schwere Hauptgruppenmetall Bi sein. Bismut hat sich aufgrund seiner ökonomischen und prozesstechnischen Eigenschaften als besonders geeignet erwiesen. Es existiert eine Vielzahl von Komplexverbindungen, welche sich im Rahmen von Nass- oder Gasphasenprozessen besonders effizient mit organischen Fluoreszenz-Emittern verarbeiten lassen. Obwohl Bismut im Periodensystem direkt hinter dem Blei folgt, hat es ganz andere physiologische Eigenschaften. Dadurch, dass es nur schwer über den Magen-Darm-Trakt aufgenommen werden kann, sind Vergiftungen mit Bismut eher selten. Im Gegenteil, Salze von Bismut werden zur Behandlung von Magengeschwüren oder Syphilis in der Medizin eingesetzt. Auch als Kontrastmittel für Röntgenuntersuchungen fand es Verwendung. Von Bismut kommt nur das Isotop mit der Masse 209 natürlich vor. Es ist mit einer Halbwertszeit von 1,9 1019 Jahren ein radioaktiver α-Strahler. Aus der langen Halbwertszeit ergibt sich für 1 kg eine Aktivität von 0,0033 Bq. Diese ist damit ca. 10 Millionen mal geringer als die des in Organismen vorkommenden Kaliums. Ein Kilogramm Kalium enthält von Natur aus 0,012 Prozent also 0,12 Gramm des radioaktiven Isotops 40K mit einer Halbwertszeit t_{1/2} von 1,248 x 109 Jahren = 39,38x10¹⁵ Sekunden, und besitzt eine Atommasse von 39,96. Daraus ergibt sich eine Radioaktivität von 31825 Bq. Damit ist die Radioaktivität des Bismuts für praktische Anwendungen vernachlässigbar klein und wäre von einem Menschen, der den Geigerzähler hält nicht einmal nachweisbar. Bismut besitzt, im Gegensatz zu Iridium (3/2)und Europium (5/2), einen Kernspin von (9/2). Dieser ist in der Lage mit ungepaarten Elektronen zu koppeln, die sich auf Liganden befinden (siehe auch "Synthesen und Eigenschaften neuer Tris(fluorphenyl)antimon- und -bismut- Verbindungen. Kristallstruktur von Tkis(2,6-difluorphenyl)bismut" von T. Lewe et al. Z. anorg. allg. Chem. 622 (1996) 2009-2015). Diese Eigenschaften und die Tatsache, dass die Bismut- im Vergleich zu den Iridiumvorkommen praktisch keiner Beschränkung unterliegen können zu einer dramatisch besseren Edukt-Kostensituation führen.

In einem weiteren Aspekt des Verfahrens kann das Aufbringen der einzelnen Schichten vor dem zur Reaktion bringen wiederholt erfolgen und die Anzahl einzeln abgeschiedener Schichten größer oder gleich 3 und kleiner oder gleich 100 betragen. Im Rahmen des vorgestellten Verfahrens ist es weiterhin möglich, größere Schichtdicken zu erzeugen, ohne zu lange Diffusionswege der einzelnen Spezies in Kauf zu nehmen. Dies erfolgt dadurch, dass das sequenzielle Abscheiden häufiger erfolgt und dass zur Reaktion bringen der gesamten Schichten erst im Anschluss an das wiederholte Aufbringen ausgeführt wird. Derart lassen sich Schichtstapel erzeugen, wobei der Diffusionsweg der einzelnen Spezies minimiert wird. Die Gesamtschichtdicke der erhältlichen Schicht nach der Reaktion kann dabei größer oder gleich 1 nm und kleiner oder gleich 100 nm, bevorzugterweise größer oder gleich 3 nm und kleiner oder gleich 75 nm, des Weiteren bevorzugt größer oder gleich 5 nm und kleiner oder gleich 30 nm betragen.

In einem zusätzlichen Aspekt des erfindungsgemäßen Verfahrens kann der Anteil organischer Emitter F, welche nicht direkt an den Metallkomplex gekoppelt sind, sondern sich zwischen den einzelnen Metallkomplexen befinden größer oder gleich 0,1 % und kleiner oder gleich 50 %, bevorzugt größer oder gleich 1 % und kleiner oder gleich 25 %, des Weiteren bevorzugt größer oder gleich 5 % und kleiner oder gleich 20 % betragen.

Der Prozentanteil ergibt sich dabei als Quotient aus organischen Emittern F, welche sich zwischen den Metallkomplexen befinden und Emittern F, welche direkt an ein Metallatom koordiniert sind. Eine Möglichkeit zur Bestimmung der einzelnen Anteile besteht beispielsweise darin, dass die Schicht in einem geeigneten Lösungsmittel aufgelöst und massenspektroskopisch untersucht wird.

In einer weiteren, bevorzugten Ausführungsform des Verfahrens, kann mindestens eine untere Schicht über ein Evaporationsverfahren und mindestens eine obere Schicht über ein Lösemittelverfahren abgeschieden werden. Durch diese Möglichkeit der Prozessführung, lassen sich die Vorteile eines Nass- und eines Vakuumprozesses miteinander kombinieren. So lassen sich beispielsweise nicht alle organischen Emitter und nicht alle Metallkomplexe gleich gut aus Lösung verarbeiten oder verdampfen. Innerhalb dieses Verfahrens kann deshalb die Komponente, welche sich besser aus Lösung verarbeiten lässt im Rahmen eines Lösemittelprozesses eingesetzt und diejenige Komponente, welche sich gut verdampfen lässt, im Rahmen eines Vakuumprozesses abgeschieden werden. Die Reihenfolge der Prozessführung lässt sich natürlich auch umkehren. So kann beispielsweise auch eine 1. Schicht über ein Lösemittelverfahren abgeschieden und die 2. Schicht über ein Vakuumprozess aufgebracht werden. Das Aufbringen der 2. Schicht erfolgt dann zweckmäßigerweise erst nach Abdampfen des Lösungsmittels in einem Zwischenschritt.

Zusätzlichen Aspekt des Verfahrens können die organischen Komplexliganden L des Metallkomplexes M unabhängig voneinander ausgesucht sein aus der Gruppe umfassend fluorierte oder nicht-fluorierte C1-C30 Alkyl- oder Aryl-Carboxylate, -Alkoholate, -Thiolate, -Cyanate, -Isocyanate, -Thiocyanate, -Acetylacetonate, -Sulfonate. Diese Liganden im Metallkomplex können zu einer leichten Verarbeitbarkeit in Nass- wie auch Gasphasenprozessen führen und können aufgrund Ihrer Koordinationseigenschaften zum Metallatom zu einer einfachen Änderung der Koordinationssphäre des Metallatoms beitragen. Innerhalb des Metallkomplexes kann/können dabei nur ein oder aber auch mehrere der oben genannten Liganden vorliegen. Bevorzugt kann der Komplex gemischte Liganden aufweisen. Dies entweder durch Erweiterung der Koordinationssphäre des Metallatoms bei tragen. Innerhalb des Metallkomplexes kann/können dabei nur ein oder aber auch mehrere der oben genannten Liganden vorliegen. Bevorzugt kann der Komplex gemischte Liganden aufweisen. Dies entweder durch Erweiterung der Koordinationssphäre des Metalls oder durch Ersatz eines einzelnen oder mehrerer Liganden. Diese Liganden können zudem zur Justage der Emissionswellenlänge des organischen Emitters genutzt werden. Dies kann durch elektronische Wechselwirkungen des oder der Liganden mit dem Emitter hervorgerufen werden. Diese Liganden L im Metallkomplex können bevorzugt einen Anteil von größer oder gleich 0 % und kleiner oder gleich 20 % an der gesamten Emissionsausbeute der Schicht ausmachen. Bevorzugt kann dieser Bereich zwischen größer oder gleich 0 % und kleiner oder gleich 10 % und des Weiteren bevorzugt zwischen größer oder gleich 0 % und kleiner oder gleich 5 % liegen.

Des Weiteren können in einem weiteren Aspekt des Verfahrens die Liganden L des Metallkomplexes unabhängig voneinander aus der Gruppe umfassend C6-C30 Aromaten und Heteroaromaten ausgewählt sein. Diese Aromaten oder Heteroaromaten können zu einer leichten Verarbeitbarkeit in Nass- wie auch Gasphasenprozessen beitragen und ermöglichen den organischen Emittern zudem eine einfache Koordination an das Metallatom und den Einbau in die thermodynamisch günstigen Zwischenkomplexpositionen. Die Wechselwirkungen der π-Elektronen können zudem die Lage der Phosphoreszenz-Wellenlängen des organischen Emitters beeinflussen und so zu einem veränderten Emissionsspektrum des Emitters und damit auch der Schicht beitragen.

In einer weiteren bevorzugten Ausführungsform kann der Metallkomplex ein Bi(III) und mindestens einen Komplexliganden aus der Gruppe der nicht substituierten, partiell fluorierten oder per-fluorierten organischen Carbonsäuren enthalten. Bevorzugt kann der Metallkomplex ein, zwei oder drei dieser organischen Carbonsäuren enthalten. Organische Carbonsäuren können dabei generell aus der Gruppe der aliphatisch, gesättigten Monocarbonsäuren; aliphatisch, ungesättigten Monocarbonsäuren; aliphatisch, gesättigten Dicarbonsäuren; aliphatisch, gesättigte Tricarbonsäuren; aliphatisch, ungesättigten Dicarbonsäuren; aromatischen Carbonsäuren; heterocyclischen Carbonsäuren; aliphatisch, ungesättigten, cyclischen Monocarbonsäuren ausgewählt werden. Besonders bevorzugte partielle oder perfluorierte Liganden L können aus substituierten oder unsubstituierten Verbindungen der Essigsäure, Phenylessigsäure und/oder Benzoesäure ausgewählt werden. Besonders bevorzugt kann nicht-fluorierte, partiell fluorierte oder perfluorierte Essigsäure eingesetzt werden. In einer weiteren bevor-zugten Ausführungsform können ein oder mehrere mehrzähnige Liganden L im unverdampften Zustand verbrückend zwischen den Metallatomen des Komplexes angeordnet sein. Diese Verbindungen lassen sich einfach sowohl aus der Nassphase als auch über ein Gasphasenabscheidungsverfahren verarbeiten und ermöglichen eine gute Anbindung des fluoreszenten Emitters in der Schicht. Sie können derart zu langlebigen Emitter-Bauteilen führen, welche eine sehr gute Quantenausbeute aufweisen.

In einer weiteren Ausgestaltung des Verfahrens können die organischen Komplexliganden L des Metallkomplexes M unabhängig voneinander ausgesucht sein aus der Gruppe umfassend fluorierte oder nicht fluorierte aliphatische C1-C30 Carboxylate. Gerade die Koordination der Liganden über zwei Sauerstoffatome an das schwere Hauptgruppenmetall kann eine erleichterte Änderung der Koordinationssphäre durch den Eintritt des organischen Fluoreszenz-Emitters ermöglichen. Durch diese Konfiguration können besonders stabile und effiziente Schichten mit langen Lebensdauern erhalten werden. Zudem scheinen die sterischen Eigenschaften der aliphatischen Carboxylate besonders dazu geeignet, dass die weiteren organischen Emitter, welche nicht direkt in die Koordinationssphäre des Metallatoms eingebaut sind, noch einen genügend kleinen Abstand zu den Metallatomen einnehmen zu können, welches eine effektive Öffnung des Phosphoreszenzkanals ermöglicht. Demzufolge erhält man auch einen effektiven Beitrag über die nicht direkt gebundenen organischen Emitter. Bevorzugterweise kann es sich bei den Komplexliganden L auch um fluorierte oder nicht-fluorierte aliphatische C1-C20 Carboxylate und des Weiteren bevorzugt um fluorierte oder nicht-fluorierte lineare aliphatische C1-C20 Carboxylate handeln.

Des Weiteren kann in einem zusätzlichen Aspekt des Verfahrens der Metallkomplex K mindestens zwei unterschiedliche organische Komplexliganden L umfassen. Für den Aufbau effektiver organischer zur Phosphoreszenz befähigter Emitter hat es sich als geeignet erwiesen, dass der Metallkomplex K mindestens 2 unterschiedliche organische Liganden umfasst. Ohne durch die Theorie gebunden zu sein kann dies deshalb vorteilhaft sein, da eine Ligandenart sich besonders leicht durch einen fluoreszenten Emitter ersetzen lässt und die andere Ligandenart eine effektive Wechselwirkung eines organischen Emitter F ermöglicht, welcher nicht direkt an den Metallkomplex gebunden ist. Dies beispielsweise bedingt durch besondere sterische Voraussetzungen oder einen besonderen elektronischen Aufbau des Liganden. Derart lassen sich die Positionen der nicht direkt gebundenen organischen Emitter beeinflussen und damit die emissiven und absorbierenden Eigenschaften der resultierenden Schicht adaptieren.

In einer weiteren Charakteristik des Verfahrens kann der Metallkomplex K eine oder mehrere Verbindungen aus der Gruppe Bi(III)triacetat, Bi(III)trifluoroacetat, Bi(III)tris-3,5-difluorobenzoat, Bi(III)tris-3,4,5-trifluorobenzoat, Bi(III)tris-2,3,5,6-tertrafluorobenzoat, Bi(III)tris-2,3,4,5,6-pentafluorobenzoat, Bi(III)tris-2,3,5,6-tetrafluoro-4-trifluoromethyl-benzoat, Bi(III)tris-3,5-trifluoromethylbenzoat, Bi(III)pentafluorobenzoat und Bi(III)3,5 trifluormethylbenzoat umfassen. Gerade die Koordination der Liganden über zwei Sauerstoffatome an das schwere Hauptgruppenmetall kann eine erleichterte Änderung der Koordinationssphäre durch den Eintritt des organischen Fluoreszenz-Emitters ermöglichen. Durch diese Konfiguration können besonders stabile und effiziente Schichten mit langen Lebensdauern hergestellt werden. Des Weiteren ermöglichen oben genannte Liganden zudem noch eine effektive Wechselwirkung der nicht direkt gebundenen organischen Emitter mit den schweren Metallatomen.

In einem zusätzlichen Aspekt der Erfindung kann der Metallkomplex mindestens einen Substituenten umfassen, welcher ausgewählt ist aus der Gruppe:
- fluorierte Benzoate
   wie z.B. 2-(Trifluoromethyl)benzoat; 3,5-Difluorobenzoat; 3-Hydroxy-2,4,6-triiodobenzoat; 3-Fluoro-4-methylbenzoat; 3-(Trifluoromethoxy)benzoat; 4-(Trifluoromethoxy)benzoat; 4-Chloro-2,5-difluorobenzoat; 2-Chloro-4,5-difluorobenzoat; 2,4,5-Trifluorobenzoat; 2-Fluorobenzoat; 4-Fluorobenzoat; 2,3,4-Trifluorobenzoat; 2,3,5-Trifluorobenzoat; 2,3-Difluorobenzoat; 2,4-Bis(trifluoromethyl)benzoat; 2,4-Difluorobenzoat; 2,5-Difluorobenzoat; 2,6-Bis(trifluoromethyl)benzoat; 2,6-Difluorobenzoat; 2-Chloro-6-fluorobenzoat; 2-Fluoro-4-(trifluoromethyl)benzoat; 2-Fluoro-5-(trifluoromethyl)benzoat; 2-Fluoro-6-(trifluoromethyl)benzoat; 3,4,5-Trifluorobenzoat; 3,4-Difluorobenzoat; 3,5-Bis(trifluoromethyl)benzoat; 3-(Trifluoromethyl)benzoat; 3-Chloro-4-fluorobenzoat; 3-Fluoro-5-(trifluoromethyl)benzoat; 3-Fluorobenzoat; 4-Fluoro-2-(trifluoromethyl)benzoat; 4-Fluoro-3-(trifluoromethyl)benzoat; 5-Fluoro-2-methylbenzoat; 2-(Trifluoromethoxy)benzoat; 2,3,5-Trichlorobenzoat; 4-(Trifluoromethyl)benzoat; Pentafluorobenzoat; 2,3,4,5-Tetrafluorobenzoat; 2,3,5,6-Tetrafluoro-4-(trifluoromethyl)benzoat;
- fluorierte oder nicht-fluorierte Phenylacetate
   wie z.B. 2-Fluor-Phenylacetat; 3-Fluor-Phenylacetat; 4-Fluor-Phenylacetat; 2,3-Difluor-Phenylacetat; 2,4-Difluor-Phenylacetat; 2,6-Difluor-Phenylacetat; 3,4-Difluor-Phenylacetat; 3,5-Difluor-Phenylacetat; Pentafluor-Phenylacetat; 2-Chloro-6-fluor-Phenylacetat; 2-Chloro-3,6-difluor-Phenylacetat; 3-Chloro-2,6-difluor-Phenylacetat; 3-Chloro-4-fluor-Phenylacetat; 5-Chloro-2-fluor-Phenylacetat; 2,3,4-Trifluor-Phenylacetat; 2,3,5-Trifluor-Phenylacetat; 2,3,6-Trifluor-Phenylacetat; 2,4,5-Trifluor-Phenylacetat; 2,4,6-Trifluor-Phenylacetat; 3,4,5-Trifluor-Phenylacetat; 3-Chloro-2-fluor-Phenylacetat; α-Fluor-Phenylacetat; 4-Chloro-2-fluor-Phenylacetat; 2-Chloro-4-fluor-Phenylacetat; α,α-Difluor-Phenylacetat; Ethyl 2,2-Difluor-2-phenylacetate;
- fluorierte oder nicht-fluorierte Acetate
   wie z.B. Methyl-trifluoroacetat; Allyl-trifluoroacetat; Ethyl-trifluoroacetat; Isopropyl-trifluoroacetat; 2,2,2-Trifluoroethyl-trifluoroacetat; Difluoroacetat; Trifluoroacetat; Methyl-chlorodifluoroacetat; Ethylbromodifluoroacetat; Chlorodifluoroacetat; Ethylchlorofluoroacetat; Ethyl-difluoroacetat; (3-Chlorophenyl)-difluoracetat; (3,5-Difluorophenyl)-difluoroacetat; (4-Butylphenyl)difluoroacetat; (4-tert-Butylphenyl)difluoroacetat; (3,4-Dimethylphenyl)-difluoroacetat; (3-Chloro-4-fluorophenyl)-difluoroacetat; (4-Chlorophenyl)-difluoroacetat; 2-Biphenyl-3',5'-difluoroacetat; 3-Biphenyl-3',5'-difluoroacetat; 4-Biphenyl-3',5'-difluoroacetat; 2-Biphenyl-3',4'-difluoroacetat; 3-Biphenyl-3',4'-difluoroacetat; 4-Biphenyl-3',4'-difluoroacetat und 2,2-Difluoro-propionat.

Diese Liganden haben sich zur schnellen Umsetzung als besonders geeignet erwiesen. Es lassen sich bei kurzen Prozesszeiten hocheffiziente phosphoreszente Schichten erhalten. Es können auch die höheren Homologen dieser Verbindungen eingesetzt werden. Es kann vorteilhafterweise auch jeder Ligand des Komplexes aus oben angegebenen Verbindungen ausgesucht werden. Es kann zudem auch vorteilhaft sein, dass jeder Liganden des Komplexes nur einer der oben angegeben Verbindungen entspricht.

In einer zusätzlichen bevorzugten Ausführungsform des Verfahrens kann der Metallkomplex K ein zweikerniger Metallkomplex sein. Eine besonders günstige Konstellation kann sich dadurch ergeben, dass der Metallkomplex in der Schicht als zweikerniger Metallkomplex vorliegt. In diesem Fall können ein oder mehrere Liganden des bi-nuklearen Komplexes durch den organisch fluoreszenten Emitter F ersetzt werden oder es kann die Koordinationssphäre des bi-nuklearen Komplexes durch die Aufnahme eines oder mehrerer organischen Emitter erweitert werden. Des Weiteren können ein oder mehrere organisch fluoreszente Emitter F um den bi-nuklearen Komplex an thermodynamisch günstigen Positionen angeordnet sein. Auf diese Art und Weise kann zum Beispiel ein organisch fluoreszenter Emitter F, welcher innerhalb des Komplexes angeordnet ist, gleichzeitig mit 2 Metallatomen wechselwirken. Dies kann zu einer besonders effektiven Öffnung des Phosphoreszenzkanals beitragen. Der zweikernige Metallkomplex kann dabei sowohl homo- wie auch hetero-nuklear sein.

Des Weiteren können in einer bevorzugten Ausführungsform des Verfahrens die organisch fluoreszenten Emitter F ausgewählt sein aus der Gruppe der substituierten oder nicht substituierten C6-C60 N-Heteroaromaten. Zum Erhalt eines möglichst großen Phosphoreszenz-Beitrages des organischen fluoreszenten Emitters und einer möglichst stabilen Assoziation des Emitters an das schwere Hauptgruppenmetall können fluoreszente Emitter in diesem Größenbereich besonders vorteilhaft eingesetzt werden. Zudem lassen sich diese Emitter sowohl gut aus der Flüssig- wie auch aus der Gasphase abscheiden. Die einzelnen Moleküle können dabei sowohl vollständig aromatisch durchkonjugiert, wie auch teilweise nicht aromatische Abschnitte aufweisen. Des Weiteren können diese organisch fluoreszenten Emitter F aufgrund ihrer Größe ausreichend hohe Diffusionskoeffizienten aufweisen, so dass sich innerhalb hinreichender Prozesszeiten homogene Schichten erhalten lassen. Insbesondere scheinen auch die N-Heteroaromaten dieser Größe besonders geeignet zu sein, stabile Positionen zwischen den Metallkomplexen einzunehmen.

In einer weiteren Ausgestaltung des Verfahrens können die organisch fluoreszenten Emitter F aus der Gruppe umfassend 4,7-di(9H-carbazol-9-yl)-1,10-phenanthrolin, 2,6-bis(3-(9H-carbazol-9-yl)phenyl)pyridine, 3,5-bis(3-(9H-carbazol-9-yl)phenyl)pyridine, 2,8-di(9H-carbazol-9-yl)dibenzo[b,d]thiophene, 2,2',2"-(1,3,5-Benzinetriyl)-tris(1-phenyl-1-H-benzimidazol), 2-(4-Biphenylyl)-5-(4-tert-butylphenyl)-1,3,4-oxadiazol, 2,9-Dimethyl-4,7-diphenyl-1,10-phenanthrolin, 8-Hydroxyquinolinolato-lithium, 4-(Naphthalen-1-yl)-3,5-diphenyl-4H-1,2,4-triazol, 1,3-Bis[2-(2,2'-bipyridine-6-yl)-1,3,4-oxadiazo-5-yl]benzen, 4,7-Diphenyl-1,10-phenanthrolin, 3-(4-Biphenylyl)-4-phenyl-5-tert-butylphenyl-1,2,4-triazol, Bis(2-methyl-8-quinolinolate)-4-(phenylphenolato)aluminium, 6,6'-Bis[5-(biphenyl-4-yl)-1,3,4-oxadiazo-2-yl]-2,2'-bipyridyl, 2-phenyl-9,10-di(naphthalen-2-yl)-anthracen, 2,7-Bis[2-(2,2'-bipyridine-6-yl)-1,3,4-oxadiazo-5-yl]-9,9-dimethylfluoren, 1,3-Bis[2-(4-tert-butylphenyl)-1,3,4-oxadiazo-5-yl]benzen, 2-(naphthalen-2-yl)-4,7-diphenyl-1,10-phenanthrolin, 2,9-Bis(naphthalen-2-yl)-4,7-diphenyl-1,10-phenanthrolin, Tris(2,4,6-trimethyl-3-(pyridin-3-yl)phenyl)boran, 1-methyl-2-(4-(naphthalen-2-yl)phenyl)-1H-imidazo[4,5-f][1,10]phenanthrolin, 1,3-bis(carbazol-9-yl)benzene , 1,3-bis(carbazol-9-yl)pyridine, 1,3,5-tris(carbazol-9-yl)benzene, 9-(3-(9H-carbazol-9-yl)phenyl)-3-(4-(1-phenyl-1H-benzo[d]imidazol-2-yl)phenyl)-9H-carbazole, 2,6,14-Tris(carbazol-9-yl)triptycene, 1,3-bis(carbazol-9-yl)benzene, 1,3,5-tris(carbazol-9-yl)benzene, 3,5-di(9H-carbazol-9-yl)bipheny, 9-(3,5-bis(diphenylphosphoryl)phenyl)-9H-carbazole, Bis[3,5-di(9H-carbazol-9-yl)phenyl]diphenylsilane, 2,8-bis(diphenylphosphoryl)dibenzo[b,d]thiophen, poly[3-(carbazol-9-yl)-9-(3-methyloxetan-3-ylmethyl)carbazole], Poly[3-(carbazol-9-ylmethyl)-3-methyloxetane] ausgesucht sein. Diese Verbindungen haben sich zum Einsatz als organisch fluoreszente Emitter F als besonders geeignet, aber nicht einschränkend erwiesen. Sowohl die elektronischen wie auch sterischen Eigenschaften dieser Verbindungen erlauben ausreichende Wechselwirkungen mit den schweren Hauptgruppenmetallen zur "Öffnung" des Phosphoreszenzkanals mit guten internen Quantenausbeuten und langer Standzeit der Schichten. Zudem weisen diese Verbindungen hinreichend große aromatische Bereiche auf, welches zu geeigneten Emissionswellenlängen führen kann. Die gute Wechselwirkung der organisch fluoreszenten Emitter F kann hochwahrscheinlich auch auf deren sterische Gegebenheiten und hier insbesondere auf die geeigneten Koordinationsstellen zum Metallatom zurückgeführt werden. Zudem weisen diese Verbindungen eine gute Verarbeitung in Nass- wie auch Gasphasenabscheidungsprozessen auf.

Innerhalb einer zusätzlichen Ausführungsform des Verfahrens können die organisch fluoreszenten Emitter F ausgesucht sein aus der Gruppe umfassend 4,7-di(9H-carbazol-9-yl)-1,10-phenanthrolin, 2,6-bis(3-(9H-carbazol-9-yl)phenyl)pyridin und 3,5-bis(3-(9H-carbazol-9-yl)phenyl)pyridin. Insbesondere diese Gruppe der organisch fluoreszenten Emitter F hat sich als geeignet erwiesen, im Rahmen des erfindungsgemäßen Verfahrens sowohl als phosphoreszenter Ligand inner- und außerhalb der Koordinationssphäre des Metallkomplexes zu fungieren. Diese Emitter scheinen anscheinend eine geeignete Größe aufzuweisen, welche eine effektive Diffusion dieser Emitter gewährleistet. Des Weiteren, wahrscheinlich aufgrund ihrer elektronischen Struktur, können diese Emitter eine effektive Bindung und Kopplung an die Metallatome ermöglichen. Auf diese Art und Weise werden im Rahmen des erfindungsgemäßen Verfahrens effektive und langlebige Emitterschichten erhalten. Insbesondere oben angegebene Carbazol-tragende organische Emitter können, hochwahrscheinlich bedingt durch ihre elektronische HOMO/LUMO-Struktur, bei Raumtemperatur ohne Koordination an ein schweres Hauptgruppenmetall aus der oben angegebenen Gruppe nur reine Fluoreszenzemission zeigen. Nach Koordination oder Adduktbildung mit dem Hauptgruppenmetall werden mit hohen Quantenausbeuten phosphoreszente Emissionen beobachtbar. Diese werden im hohen Maße durch die elektronische Struktur des organischen Emitters und der restlichen Liganden des Komplexes bestimmt. Schichten mit diesem Emitter-Aufbau haben sich dabei als besonders effizient und langlebig erwiesen. Die Langlebigkeit kann dabei wahrscheinlich auf die Größe des organischen Moleküls und dessen geringe Kristallisationsneigung zurückgeführt werden.

In einer weiteren bevorzugten Ausführungsform kann der Metallkomplex ein Bi(III) und mindestens einen Komplexliganden aus der Gruppe der nicht substituierten, partiell fluorierten oder per-fluorierten organischen Carbonsäuren enthalten. Bevorzugt kann der Metallkomplex ein, zwei oder drei dieser organischen Carbonsäuren enthalten. Organische Carbonsäuren können dabei generell aus der Gruppe der aliphatisch, gesättigten Monocarbonsäuren; aliphatisch, ungesättigten Monocarbonsäuren; aliphatisch, gesättigten Dicarbonsäuren; aliphatisch, gesättigte Tricarbonsäuren; aliphatisch, ungesättigten Dicarbonsäuren; aromatischen Carbonsäuren; heterocyclischen Carbonsäuren; aliphatisch, ungesättigten, cyclischen Monocarbonsäuren ausgewählt werden. Besonders bevorzugte partielle oder perfluorierte Liganden L können aus substituierten oder unsubstituierten Verbindungen der Essigsäure, Phenylessigsäure und/oder Benzoesäure ausgewählt werden. Besonders bevorzugt kann nicht-fluorierte, partiell fluorierte oder perfluorierte Essigsäure eingesetzt werden. In einer weiteren bevor-bevorzugten Ausführungsform können ein oder mehrere mehrzähnige Liganden L im unverdampften Zustand verbrückend zwischen den Metallatomen des Komplexes angeordnet sein. Diese Verbindungen lassen sich einfach sowohl aus der Nassphase als auch über ein Gasphasenabscheidungsverfahren verarbeiten und ermöglichen eine gute Anbindung des fluoreszenten Emitters in der Schicht. Sie können derart zu langlebigen Emitter-Bauteilen führen, welche eine sehr gute Quantenausbeute aufweisen.

In einem weiteren Aspekt des Verfahrens kann der Metallkomplex eine oder mehrere Verbindungen aus der Gruppe der Trisarylbismuth(V)carboxylate umfassen. Diese Verbindungen mit Bi in der Oxidationsstufe V lassen sich besonders leicht mittels Nassphasen- oder Gasphasenabscheidung verarbeiten und ermöglichen eine gute Koordination der organischen fluoreszenten Emitter an das Bi-Zentralatom. Die so erhaltenen Schichten zeichnen sich durch eine hohe Quantenausbeute und eine geringe Kristallisationsneigung aus. Dieses kann die Lebensdauer der Schichten erhöhen. Die Fluorierung kann dabei sowohl nur ein einzelnes H-Atom bis hin zu einer Perfluorierung der Verbindung erfassen. Eine bevorzugte Verbindung dieser Verbindungslasse ist beispielsweise ganz oder teilweise fluoriertes Triphenylbismuth(V)bis(fluorobenzoat).

In einer weiteren, bevorzugten Ausführungsform kann der Metallkomplex aus der Gruppe umfassend Bi(III)triscarboxylat, Bi(III)fluoroacetat und Bi(III)trifluoroacetat ausgewählt sein. Gerade die Koordination der Liganden über zwei Sauerstoffatome an das schwere Hauptgruppenmetall kann eine erleichterte Änderung der Koordinationssphäre durch den Eintritt des organischen Fluoreszenz-Emitters ermöglichen. Durch diese Konfiguration können besonders stabile und effiziente Schichten mit langen Lebensdauern hergestellt werden.

Des Weiteren erfindungsgemäß ist ein organisch elektrisches Bauteil umfassend mindestens eine phosphoreszente Emitterschicht, hergestellt nach dem erfindungsgemäßen Verfahren. Mittels des erfindungsgemäßen Verfahrens lassen sich Schichten in organisch elektrischen Bauelementen herstellen, welche zur Emission und Umwandlung von Licht geeignet sind. Diese weisen, bedingt durch die Öffnung des Phosphoreszenz-Kanals der organisch fluoreszenten Emitter, eine hohe Quantenausbeute auf. Zudem kann sich, durch die nicht stöchiometrische Zusammensetzung von Emittern und Metallkomplexen, die Möglichkeit ergeben, dass Absorption- und Emissionsverhalten der Schichten genauer zu steuern sind. Die Phosphoreszenzeigenschaften der Schicht erhält man allerdings erst dadurch, indem man die Metallkomplexe und die organisch fluoreszenten Emitter miteinander zur Reaktion bringt.

Zusätzlich kann die erfindungsgemäße Schicht als aktive Schicht in einem organisch elektrischen Bauelement zur Umwandlung elektrischen Stroms in Licht, von Licht in elektrischen Strom und von Licht in Licht anderer Wellenlänge Verwendung finden. Die erfindungsgemäße Schicht lässt sich demzufolge zur Gewinnung von Strom durch Absorption von Lichtwellen als auch zur Erzeugung von Licht mittels eines elektrischen Stromes nutzen. Des Weiteren kann die Schicht auch zur Umwandlung von Lichtwellen in Lichtwellen einer anderen Wellenlänge genutzt werden. Dies beispielsweise durch Aufnahme von Lichtquanten und Abgabe von Lichtquanten anderer Wellenlänge.

Weiterhin erfindungsgemäß ist die Verwendung des erfindungsgemäßen Bauteils als organische Solarzelle, organischen Transistor, einem licht-emittierenden, organischen Bauteil, einer organischen Leuchtdiode und/oder einer organischen licht-emittierenden elektrochemischen Zelle. Das beschriebene Verfahren und die damit herstellbaren Schichten können entsprechend für absorbierende Bauelemente wie Photodioden oder Solarzellen Verwendung finden. Des Weiteren können die Schichten auch für Photo-Konversionsschichten in der Photovoltaik oder Sensorik eingesetzt werden. Das Verfahren ist mit den Standard-Herstellungsschritten dieser Bauelemente kompatibel und derart lassen sich kostengünstig, langlebige und effiziente Bauelemente erhalten.

Hinsichtlich weiterer Vorteile und Merkmale der vorbeschriebenen organischen Halbleiterbauelemente wird hiermit explizit auf die Erläuterungen im Zusammenhang mit der erfindungsgemäßen Schicht sowie dem erfindungsgemäßen Verfahren verwiesen. Auch sollen erfindungsgemäße Merkmale und Vorteile des erfindungsgemäßen Verfahrens auch für die erfindungsgemäße Schichten und die erfindungsgemäßen organischen Halbleiterbauelemente anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Der Aufbau von Bauteilen, welche Schichten nach dem erfindungsgemäßen Verfahren enthalten können, ist in den folgenden Figuren dargestellt. Die Figuren zeigen
- Fig. 1: schematisch den Aufbau einer organischen Leuchtdiode 10. Die Leuchtdiode ist aus einer Glas-Schicht 1; Indium-Zinn-Oxid ITO-Schicht 2; Loch-Injektor-Schicht 3; Loch-Transportschicht HTL 4; Emitter-Schicht EML 5; Loch-Blocker-Schicht HBL 6; Elektronen-Transportschicht ETL 7; Elektronen-Injektorschicht 8 und einer Kathoden-Schicht 9 aufgebaut; und
- Fig. 2: schematisch den Aufbau einer organischen Solarzelle mit PIN-Struktur 20, welche Licht 21 in elektrischen Strom umwandelt. Die Solarzelle besteht aus einer Schicht aus Indium-Zinn-Oxid 22; einer p-dotierten Schicht 23; einer Absorp-tions-Schicht 24; einer ndotierten Schicht 25 und einer Metall-Schicht 26.

### Beispiel:

Ein vorgefertigtes Quarzsubstrat wird für 10 Minuten mittels eines Sauerstoffplasmas behandelt und schnellstmöglich in einen Evaporator überführt, welcher sich innerhalb einer Argon gefüllten Glovebox mit einem Wassergehalt kleiner 2 ppm befindet.

Das thermische Verdampfen der beiden Schichten erfolgt bei einem Basisdruck kleiner als 2x10⁻⁶ mbar, welcher während des gesamten Bedampfungsschrittes beibehalten wird.

Der Metallkomplex und der organische Emitter werden in separaten Evaporatoren auf eine Temperatur kurz unterhalb ihres Verdampfungspunktes aufgeheizt. Anschließend wird der Metallkomplex solange weiter aufgeheizt, bis eine konstante Verdampfungsrate erzielt wird. Der Schieber des Evaporators wird geöffnet und eine erste Schicht des Metallkomplexes wird abgeschieden. Daraufhin wird der Evaporator wieder geschlossen. Anschließend wird der organische Emitter solange weiter aufgeheizt, bis eine konstante Verdampfungsrate erzielt ist. Der Schieber des Evaporators wird geöffnet und eine zweite Schicht des organischen Emitters wird auf die erste Schicht abgeschieden.

Nach erfolgter Bedampfung wird der Verdampfer mit trockenem Argon geflutet.

Es wurden eine Reihe Bi:BUPH1-Filme mit unterschiedlicher Zusammensetzung über das oben beschriebene Ko-Evaporationsverfahren hergestellt. Dabei wurde das Verhältnis zwischen Metallkomplex und organischen Emitter über die Schichtdicke der einzelnen Schichten geregelt. Insgesamt wurden 200 nm dicke Bi:BUPH1-Filme als Emitterschichten auf einem Quarzglas abgeschieden. Dies bedeutet beispielsweise bei einem Verhältnis von 1:2, dass die Dicke der Schicht, welche aus dem organischen Emitter gebildet wurde, doppelt so groß ist wie die Schicht, welche aus dem Metallkomplex gebildet wurde. Das zur Reaktion bringen erfolgte bei einer Temperatur von 150 °C über einen Zeitraum von ungefähr 60 Minuten. Es wurden folgende Verhältnisse eingestellt(die Abkürzungen von Bismuth(III)trifluoroacetat Bi(tfa)₃ und die von Bi(III)Pentafluorobenzoat Bi(pFBz)₃):

| Verbindung | Verhältnis |
|---|---|
| Bi(tfa)₃ : BUPH1 | 1:2 |
| Bi(tfa)₃ : BUPH1 | 1:3 |
| Bi(tfa)₃ : BUPH1 | 1:4 |
| Bi(tfa)₃ : BUPH1 | 3:1 |
| Bi(pFBz)₃ : BUPH1 | 1:1 |
| Bi(pFBz)₃ : BUPH1 | 1:2 |
| Bi(pFBz)₃ : BUPH1 | 1:3 |

Die mit unterschiedlichen Zusammensetzungen abgeschiedenen Bi(tfa)3:BUPH1- und Bi(pFBz)3:BUPH1-Filme wurden mittels TCSPC-Messungen (time-correlated single photon counting) in einer inerten Atmosphäre untersucht. Bei Raumtemperatur liefert die TCSCP-Messung für die Bi:BUPH1-Filme komplexe Lebensdauern im Mikrosekunden-Bereich. Dies ist ein klarer Hinweis für das Vorliegen eines Phosphoreszenzüberganges. Die komplexen Lebensdauern in dieser Zeitdomäne können zudem auf das Vorliegen direkt an das Schwermetallatom und in der weiteren Umgebung gebundener, nun phosphoreszenter Emitter hindeuten.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Herstellung phosphoreszenter Emitterschichten aus mindestens einem organisch fluoreszenten Emitter F und mindestens einem Metallkomplex K umfassend organische Komplexliganden L und mindestens ein schweres Hauptgruppenmetall M ausgesucht aus der Gruppe umfassend In, Tl, Sn, Pb, Sb und Bi, **dadurch gekennzeichnet, dass** der organisch fluoreszente Emitter F und der Metallkomplex K jeweils einzeln und schichtweise auf einem Substrat abgeschieden und anschließend miteinander zur Reaktion gebracht werden, wobei das schwere Hauptgruppenmetall M seine Koordinationssphäre unter Aufnahme des organisch fluoreszenten Emitters F ändert.

2. Verfahren nach Anspruch 1, wobei das zur Reaktion bringen durch Hitzeeinwirkung bei einer Temperatur von größer oder gleich 50 °C und kleiner oder gleich 300 °C erfolgt.

3. Verfahren nach einem der vorhergehenden Ansprüche, wobei das Schichtdickenverhältnis zwischen organisch fluoreszenter Emitter- und Metallkomplexschicht vor der Reaktion größer oder gleich 0,1 und kleiner oder gleich 15 beträgt.

4. Verfahren nach einem der vorhergehenden Ansprüche, wobei das schwere Hauptgruppenmetall Bi ist.

5. Verfahren nach einem der vorhergehenden Ansprüche, wobei das Aufbringen der einzelnen Schichten vor dem zur Reaktion bringen wiederholt erfolgt und die Anzahl einzeln abgeschiedener Schichten größer oder gleich 3 und kleiner oder gleich 100 beträgt.

6. Verfahren nach einem der vorhergehenden Ansprüche, wobei mindestens eine untere Schicht über ein Evaporationsverfahren und mindestens eine obere Schicht über ein Lösemittelverfahren abgeschieden wird.

7. Verfahren nach einem der vorhergehenden Ansprüche, wobei die organischen Komplexliganden L des Metallkomplexes M unabhängig voneinander ausgesucht sind aus der Gruppe umfassend fluorierte oder nicht-fluorierte C1-C30 Alkyl- oder Aryl-Carboxylate, -Alkoholate, -Thiolate, -Cyanate, -Isocyanate, -Thiocyanate, -Acetylacetonate, -Sulfonate.

8. Verfahren nach einem der vorhergehenden Ansprüche, wobei die organischen Komplexliganden L des Metallkomplexes M unabhängig voneinander ausgesucht sind aus der Gruppe umfassend fluorierte oder nicht fluorierte aliphatische C1-C30 Carboxylate.

9. Verfahren nach einem der vorhergehenden Ansprüche, wobei der Metallkomplex K mindestens zwei unterschiedliche organische Komplexliganden L umfasst.

10. Verfahren nach einem der vorhergehenden Ansprüche, wobei der Metallkomplex K eine oder mehrere Verbindungen aus der Gruppe Bi(III)triacetat, Bi(III)trifluoroacetat, Bi(III)tris-3,5-difluorobenzoat, Bi(III)tris-3,4,5-trifluorobenzoat, Bi(III)tris-2,3,5,6-tertrafluorobenzoat, Bi(III)tris-2,3,4,5,6-pentafluorobenzoat, Bi(III)tris-2,3,5,6-tetrafluoro-4-trifluoromethyl-benzoat, Bi(III)tris-3,5-trifluoromethylbenzoat, Bi(III)pentafluorobenzoat und Bi(III)3,5trifluormethylbenzoat umfasst.

11. Verfahren nach einem der vorhergehenden Ansprüche, wobei der Metallkomplex K ein zweikerniger Metallkomplex ist.

12. Verfahren nach einem der vorhergehenden Ansprüche, wobei die organisch fluoreszenten Emitter F ausgewählt sind aus der Gruppe der substituierten oder nicht substituierten C6-C60 N-Heteroaromaten.

13. Verfahren nach einem der vorhergehenden Ansprüche, wobei die organisch fluoreszenten Emitter F ausgesucht sind aus der Gruppe umfassend 4,7-di(9H-carbazol-9-yl)-1,10-phenanthrolin, 2,6-bis(3-(9H-carbazol-9-yl)phenyl)pyridin und 3,5-bis(3-(9H-carbazol-9-yl)phenyl)pyridin.

14. Organisch elektrisches Bauteil umfassend mindestens eine phosphoreszente Emitterschicht hergestellt nach einem Verfahren nach einem der Ansprüche 1-13.

15. Verwendung eines Bauteils nach Anspruch 14 als organische Solarzelle, organischen Transistor, einem licht-emittierenden, organischen Bauteil, einer organischen Leuchtdiode und/oder einer organischen licht-emittierenden elektrochemischen Zelle.

## Claims

1. Process for producing phosphorescent emitter layers composed of at least one organic fluorescent emitter F and at least one metal complex K comprising organic complex ligands L and at least one heavy main group metal M selected from the group comprising In, Tl, Sn, Pb, Sb and Bi, **characterized in that** the organic fluorescent emitter F and the metal complex K are each deposited individually and layer by layer on a substrate and then reacted with one another, in the course of which the heavy main group metal M changes its coordination sphere to incorporate the organic fluorescent emitter F.

2. Process according to Claim 1, wherein the reacting is effected by heating at a temperature of not less than 50°C and not more than 300°C.

3. Process according to either of the preceding claims, wherein the layer thickness ratio between the organic fluorescent emitter layer and metal complex layer prior to the reaction is not less than 0.1 and not more than 15.

4. Process according to any of the preceding claims, wherein the heavy main group metal is Bi.

5. Process according to any of the preceding claims, wherein the applying of the individual layers is effected repeatedly prior to the reacting and the number of individually deposited layers is not less than 3 and not more than 100.

6. Process according to any of the preceding claims, wherein at least one lower layer is deposited via an evaporation process and at least one upper layer via a solvent process.

7. Process according to any of the preceding claims, wherein the organic complex ligands L of the metal complex M are independently selected from the group comprising fluorinated or non-fluorinated C1-C30 alkyl or aryl carboxylates, alkoxides, thiolates, cyanates, isocyanates, thiocyanates, acetylacetonates, sulfonates.

8. Process according to any of the preceding claims, wherein the organic complex ligands L of the metal complex M are independently selected from the group comprising fluorinated or non-fluorinated aliphatic C1-C30 carboxylates.

9. Process according to any of the preceding claims, wherein the metal complex K comprises at least two different organic complex ligands L.

10. Process according to any of the preceding claims, wherein the metal complex K comprises one or more compounds from the group of Bi(III) triacetate, Bi(III) trifluoroacetate, Bi(III) tris-3,5-difluorobenzoate, Bi(III) tris-3,4,5-trifluorobenzoate, Bi(III) tris-2,3,5,6-tetrafluorobenzoate, Bi(III) tris-2,3,4,5,6-pentafluoro-benzoate, Bi(III) tris-2,3,5,6-tetrafluoro-4-trifluoro-methylbenzoate, Bi(III) tris-3,5-trifluoromethylbenzoate, Bi(III) pentafluorobenzoate and Bi(III) 3,5-trifluoro-methylbenzoate.

11. Process according to any of the preceding claims, wherein the metal complex K is a dinuclear metal complex.

12. Process according to any of the preceding claims, wherein the organic fluorescent emitters F are selectedfrom the group of the substituted or unsubstituted C6-C60 N-heteroaromatics.

13. Process according to any of the preceding claims, wherein the organic fluorescent emitters F are selected from the group comprising 4,5-di(9H-carbazol-9-yl)-1,10-phenanthroline, 2,6-bis(3-(9H-carbazol-9-yl)phenylpyridine and 3,5-bis(3-(9H-carbazol-9-yl)phenyl)pyridine.

14. Organic electrical component comprising at least one phosphorescent emitter layer produced by a process according to any of Claims 1-13.

15. Use of a component according to Claim 14 as organic solar cell, organic transistor, a light-emitting organic component, an organic light-emitting diode and/or an organic light-emitting electrochemical cell.

## Revendications

1. Procédé de production de couches émettrices phosphorescentes en au moins un émetteur F fluorescent de manière organique et en au moins un complexe K métallique, comprenant des ligands L organiques du complexe et au moins un métal M lourd du groupe principal choisi dans le groupe comprenant In, Tl, Sn, Pb, Sb et Bi, **caractérisé en ce que** l'on dépose, sur un substrat, respectivement, individuellement et couche par couche, l'émetteur F fluorescent de manière organique et le complexe K métallique et en les mettant ensuite à réagir entre eux, le métal M lourd du groupe principal modifiant sa sphère de coordination en absorbant l'émetteur F fluorescent de manière organique.

2. Procédé suivant la revendication 1, dans lequel la mise en réaction s'effectue par action de la chaleur à une température supérieure ou égale à 50°C et inférieure ou égale à 300°C.

3. Procédé suivant l'une des revendications précédentes, dans lequel le rapport d'épaisseur de couche entre la couche d'émetteur fluorescent de manière organique et la couche de complexe métallique, avant la réaction, est supérieur ou égal à 0,1 et inférieur ou égal à 15.

4. Procédé suivant l'une des revendications précédentes, dans lequel le métal lourd du groupe principal est Bi.

5. Procédé suivant l'une des revendications précédentes, dans lequel on effectue le dépôt des diverses couches de manière répétée avant la mise en réaction et le nombre des couches déposées individuellement est supérieur ou égal à 3 et inférieur ou égal à 100.

6. Procédé suivant l'une des revendications précédentes, dans lequel on dépose au moins une couche inférieure par un procédé d'évaporation et au moins une couche supérieure par un procédé par solvant.

7. Procédé suivant l'une des revendications précédentes, dans lequel on choisit les ligands L organiques du complexe M métallique, indépendamment les uns des autres, dans le groupe comprenant des carboxylates, alcoolates, thiolates, cyanates, isocyanates, thiocyanates, acétylacétonates et sulfonates d'alcoyle, ayant de 1 à 30 atomes de carbone dans la partie alcoylique, ou d'aryle, fluorés ou non fluorés.

8. Procédé suivant l'une des revendications précédentes, dans lequel on choisit les ligands L organiques du complexe M métallique indépendamment les uns des autres dans le groupe comprenant des carboxylates aliphatiques ayant de 1 à 30 atomes de carbone dans la partie aliphatique, fluorés ou non fluorés.

9. Procédé suivant l'une des revendications précédentes, dans lequel le complexe K métallique comprend au moins deux ligands L organiques différents.

10. Procédé suivant l'une des revendications précédentes, dans lequel le complexe M métallique comprend un ou plusieurs composés choisis dans le groupe triacétate de Bi(III), trifluoroacétate de Bi(III), tris-3,5-difluorobenzoate de Bi(III), tris-3, 4, 5-trifluorobenzoat de Bi(III), tris-2, 3, 5, 6-tétrafluorobenzoate de Bi(III), tris-2, 3, 4, 5, 6-pentafluorobenzoate de Bi(III), tris-2, 3, 5, 6-tetrafluoro-4-trifluorométhyl-benzoate de Bi(III), tris-3, 5-trifluorométhylbenzoat de Bi(III), pentafluorobenzoate de Bi(III) et 3,5 trifluorméthylbenzoate de Bi(III).

11. Procédé suivant l'une des revendications précédentes, dans lequel le complexe K métallique est un complexe métallique à deux noyaux.

12. Procédé suivant l'une des revendications précédentes, dans lequel l'émetteur F fluorescent de manière organique est choisi dans le groupe des hétéroatomes azotés, ayant de 6 à 60 atomes de carbone, substitués ou non substitués.

13. Procédé suivant l'une des revendications précédentes, dans lequel l'émetteur F fluorescent de manière organique est choisi dans le groupe comprenant la 4,7-di (9H-carbazol-9-yl)-1,10-phénantroline, la 2,6-bis(3-(9H-carbazol-9-yl)phényl)pyridine et la 3,5-bis(3-(9H-carbazol-9-yl)phényl)pyridine.

14. Pièce électrique de manière organique, comprenant au moins une couche émettrice phosphorescente, fabriquée suivant un procédé selon l'une des revendications 1 à 13.

15. Utilisation d'une pièce suivant la revendication 14, comme pile solaire organique, comme transistor organique, comme pièce organique émettant de la lumière, comme diode électroluminescente et/ou comme cellule électrochimique organique émettant de la lumière.
